(19) Europäisches Patentamt
European Patent Office
Office européen des brevets

(11) Veröffentlichungsnummer: **0 035 160**
**B1**

(12) # EUROPÄISCHE PATENTSCHRIFT

(45) Veröffentlichungstag der Patentschrift: **29.06.83**

(51) Int. Cl.³: **G 11 C 11/34**

(21) Anmeldenummer: **81101105.5**

(22) Anmeldetag: **17.02.81**

(54) **Halbleiter-Speicherzelle mit schwebendem Gate mit Schreib- und Lösch-Elektroden.**

(30) Priorität: **01.03.80 DE 3007892**

(43) Veröffentlichungstag der Anmeldung: **09.09.81 Patentblatt 81/36**

(45) Bekanntmachung des Hinweises auf die Patenterteilung: **29.06.83 Patentblatt 83/26**

(84) Benannte Vertragsstaaten: **DE FR GB IT NL**

(56) Entgegenhaltungen:

DE-A-2 445 091
US-A-4 122 544
US-A-4 184 207

ELECTRONICS, vol. 53, no. 5, Februar 1980, New York, U.S.A.,
JOHNSON et al.: «16-K EE-PROM relies on tunneling for byte-erasable program storage», Seiten 113-117
ELEKTRONIK, vol. 28, no. 21, Oktober 1979, München, DE,
WANKA: «Fortschritte bei nichtflüchtigen Halbleiterspeichern», Seiten 43-46
IEEE TECHNICAL DIGEST 1975, International electron devices meeting, Dezember 1, 2, 3, 1975, Washington, New York, U.S.A.,
RAI et al.: «Electrically reprogrammable nonvolatile semiconductor memory with MNMoOS (Metal-Nitride-Molybdenum-Oxide-Silicon) structure», Seiten 313-316

(73) Patentinhaber: **Deutsche ITT Industries GmbH, Hans-Bunte-Strasse 19 Postfach 840, D-7800 Freiburg (DE)**
(84) Benannte Vertragsstaaten: **DE**

(73) Patentinhaber: **ITT INDUSTRIES INC., 320 Park Avenue, New York, NY 10022 (US)**
(84) Benannte Vertragsstaaten: **FR GB IT NL**

(72) Erfinder: **Adam, Fritz Günter Dr. rer.nat. Dipl.-Phys., Furtwänglerstrasse 10, D-7800 Freiburg i.Br. (DE)**

(74) Vertreter: **Stutzer, Gerhard, Dr., Deutsche ITT Industries GmbH Patent- und Lizenzabteilung Hans-Bunte-Strasse 19 Postfach 840, D-7800 Freiburg (DE)**

EP 0 035 160 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Halbleiter-Speicherzelle mit schwebendem Gate mit Schreib- und Lösch-Elektroden

Die Erfindung beschäftigt sich mit einer nichtflüchtigen Speicherzelle, die einen n-Kanal-Floating-Gate-Speichertransistor enthält, der elektrisch geschrieben oder gelöscht werden kann, wobei sowohl beim Schreiben als auch beim Löschen keine heissen Elektronen verwendet werden. Schreiben und Löschen erfolgt vielmehr durch eine Tunnel-Injektion bzw. -Emission von (kalten) Elektronen in die bzw. aus der potentialmässig schwebenden Gate-Elektrode.

Aus den Zeitschriften «Electronics» vom 13. September 1979, Seiten 39 und 40, und vom 11. Oktober 1979, Seiten 111 bis 116, war eine solche Speicherzelle bekannt, welche einen n-Kanal-Feldeffekttransistor enthält, dessen Gate-Elektrode potentialmässig schwebend Elektrodenteile aus polykristallinem Silicium aufweist, die kapazitiv an eine aus polykristallinem Silicium bestehende Schreib-Elektrode und eine Programmier- und Lösch-Elektrode gekoppelt sind.

Beim Schreiben und Löschen tunneln die Elektronen jeweils durch eine dünne durch thermische Oxidation auf Poly-Silicium erzeugte Oxidschicht aus dem Poly-Silicium in eine darüberliegende leitende Schicht.

Die bekannte Speicherzelle enthält ferner eine Flipflop-Zelle mit sechs Feldeffekttransistoren, deren Inhalt im Bedarfsfall in die Halbleiter-Speicherzelle mit der potentialschwebenden Gate-Elektrode geschrieben werden kann. Der Platzbedarf bei der bekannten Speicherzelle ist daher relativ gross.

Die Erfindung geht von der bekannten Speicherzelle aus und betrifft somit eine Halbleiter-Speicherzelle nach dem Oberbegriff des Anspruchs 1.

Aufgabe der Erfindung ist die Angabe einer Halbleiter-Speicherzelle, welche eine wesentlich geringere Oberfläche erfordert als die bekannte.

Diese Aufgabe wird erfindungsgemäss durch die im kennzeichnenden Teil des Anspruchs 1 angegebene Ausbildung gelöst.

Vorzugsweise sind, wie bei der bekannten Speicherzelle, die Schreib-Elektrode über eine erste Isolierschicht aus einem durch thermische Oxidation auf der Schreib-Elektrode gewachsenen Oxidschicht kapazitiv mit der Gate-Elektrode und die Lösch-Elektrode über eine zweite Isolierschicht aus einem durch thermische Oxidation auf der Gate-Elektrode 1 gewachsenen Siliciumoxid kapazitiv mit der Gate-Elektrode gekoppelt. Dies erleichtert ein Tunneln der Elektronen in die bzw. aus der Gate-Elektrode, wobei die Dicken der zu durchtunnelnden Isolierschichten angrenzend an die Gate-Elektrode zwischen 10 nm (100 ÅE) und 80 nm (800 ÅE) liegen.

Aus Halbleiter-Speicherzellen nach der Erfindung lässt sich eine bitweise lösch- bzw. schreibbare Speichermatrix mit besonders geringem Platzbedarf aufbauen. Zu diesem Zweck werden die Drain-Zonen und die Source-Zonen einer Spalte, wie bei den noch zu beschreibenden Ausführungsbeispielen ersichtlich, bzw. einer Reihe, zu je einem zusammenhängenden Zonenstreifen im Substrat zusammengefasst. Quer und isoliert dazu verlaufen die Programmier-Leitstreifen, an die die Programmier-Elektroden angeschlossen sind, und die Gateleitungs-Leiterstreifen, die mit den Lösch-Elektroden elektrisch verbunden sind. Die aktiven Bereiche der einzelnen Halbleiter-Speicherzellen nach der Erfindung liegen von der betrachteten Speicherzelle aus gesehen somit jeweils in einem Rechteck, welches von den äusseren Rändern eines benachbarten Zonenstreifenpaares und einer Programmierleitung mit der benachbarten Gate-Leitung gebildet wird.

Ein besonderer Vorteil ergibt sich dadurch, dass Flächenteile der Zonenstreifen und der Leitungen zur Unterbringung der aktiven Bereiche der einzelnen Speicherzellen ausgenutzt werden können.

Die Gate-Elektrode, die Schreib-Elektrode und die unmittelbar unter der Schreib-Elektrode im sperrfreien Kontakt dazu liegende Drain-Zone werden bei der Speicherzelle nach der Erfindung n-dotiert, vorzugsweise stark n-dotiert.

Die Halbleiter-Speicherzelle nach der Erfindung wird im folgenden an Ausführungsbeispielen erläutert, welche anhand der Zeichnungen beschrieben werden, deren

Fig. 1 einen Querschnitt der Speicherzelle nach der Erfindung zur Veranschaulichung des Ausbildungsprinzips zeigt,

Fig. 2 das Prinzipschaltbild einer Vier-Bit-Speichermatrix unter Verwendung von vier Halbleiter-Speicherzellen nach der Erfindung veranschaulicht,

Fig. 3 die Aufsicht auf eine Speicherzelle eines ersten Ausführungsbeispiels bedeutet,

Fig. 4 die Aufsicht auf eine Speicherzelle eines zweiten Ausführungsbeispiels zeigt,

Fig. 5 die Aufsicht auf eine Speicherzelle eines dritten Ausführungsbeispiels ist,

Fig. 6, 7 und 8 Querschnittsansichten durch die Speicherzelle nach Fig. 5 entlang den dort angegebenen Schnittlinien zeigen,

Fig. 9 die Aufsicht auf eine Speicherzelle mit einem Lese-Feldeffekttransistor entsprechend einer Weiterbildung der Speicherzelle der Erfindung als viertes Ausführungsbeispiel veranschaulicht,

Fig. 10 das Ersatzschaltbild der Speicherzelle nach Fig. 9 bedeutet,

Fig. 11 schematisch in Schnittansicht ein fünftes Ausführungsbeispiel entsprechend einer Weiterbildung der Speicherzelle nach Fig. 9 betrifft,

Fig. 12 zur Veranschaulichung einer Weiterbildung der Speicherzelle nach Fig. 11 dient und

Fig. 13 in Aufsicht eine topologische Auslegung der Speicherzelle nach Fig. 11 zeigt.

Anhand der Fig. 1 wird im folgenden das Prinzip der Auslegung und die Funktionsweise der Speicherzelle nach der Erfindung erläutert. Zur Herstellung einer solchen Speicherzelle werden zunächst in bekannter Weise unter Anwendung der Photolithographie und eines Planardiffusionsprozesses die Source-Zone 9 und die Drain-Zone 5 in ein p-dotiertes Siliciumsubstrat 6 eindiffundiert. Auf dessen die diffundierten Zonen aufweisenden Oberflächenseite wird ein Dickoxid 11 aufgebracht. Darin wird zur Freilegung wesentlicher Oberflächenbereiche der Drain-Zone 5 und des Bereiches des Gate-Oxids 12 eine Öffnung geätzt. Daraufhin wird mit thermischer Oxidation das Gate-Oxid 12 hergestellt und die Drain-Zone 5 freigelegt. Anschliessend wird n-dotiertes polykristallines Silicium über die obere Oberflächenseite der Anordnung aufgebracht und aus der zusammenhängenden polykristallinen Siliciumschicht der über dem Gate-Oxid 12 herzustellende Teil der Gate-Elektrode 1 und die Schreib-Elektrode 4 herausgeätzt. Es erfolgt nun ein thermischer Oxidationsprozess zur Herstellung der ersten Isolierschicht 7 innerhalb der Schreib-Übergangsfläche in einer Dicke zwischen 10 nm (100 ÅE) und 80 nm (800 ÅE). In Verbindung mit der Gate-Elektrode 1 werden nun die weiteren Elektrodenteile hergestellt, welche zumindest unter der noch herzustellenden zweiten Isolierschicht 8, welche die Lösch-Übergangsfläche bildet, aus n-dotiertem polykristallinem Silicium hergestellt werden, falls die Vorteile eines für Elektronen leicht von der Gate-Elektrode 1 zur Lösch-Elektrode 3 durchtunnelbaren Übergangs entsprechend der eingangs genannten Literaturstelle wahrgenommen werden.

Zur Herstellung einer Halbleiter-Speicherzelle nach der Erfindung ist also grundsätzlich nur ein Aufbringungsprozess einer polykristallinen Silicium-Schicht unbedingt erforderlich, da lediglich die Schreib-Elektrode 4 und der unterhalb der Lösch-Elektrode 3 befindliche Elektrodenteil der Gate-Elektrode 1 aus polykristallinem Silicium bestehen muss, falls der bekannte Vorteil eines durch thermische Oxidation auf polykristallinem Silicium hergestellten und leicht zu durchtunnelnden Übergangs ausgenutzt werden soll. Die von der ersten Isolierschicht 7 gebildete Schreib-Übergangsfläche kann nämlich neben der von der zweiten Isolierschicht 8 gebildeten Lösch-Übergangsfläche unterschiedlich zur Fig. 1 angeordnet werden und die Lösch-Elektrode 3 und die Programmier-Elektrode 2 können aus einem Metall bestehen.

Nach dem Aufbringen der zweiten Isolierschicht 8 und einer dritten Isolierschicht 10 werden schliesslich die Programmier-Elektrode 2 und die Lösch-Elektrode 3 durch Aufdampfen und einen photolithographischen Ätzprozess hergestellt.

Die Fig. 2 veranschaulicht die Anwendung von Speicherzellen nach der Erfindung in einer Vier-Bit-Speichermatrix. Darin werden unabhängig von der Grösse der Matrix spaltenweise die Source-Zonen 9 zu Source-Zonenstreifen S und die Drain-Zonen 5 zu Drain-Zonenstreifen D zusammengefasst und in das Siliciumsubstrat 6 diffundiert. Die Programmierung der Speichermatrix gemäss der Fig. 2 erfolgt entsprechend der folgenden Tabelle eines Programmierbeispiels:

| | F1 | G1 | F2 | G2 | S1 | D1 | S2 | D2 |
|---|---|---|---|---|---|---|---|---|
| Lösche T11 und T12: | 0 | Up | 0 | 0 | 0 | 0 | 0 | 0 |
| Schreibe «1» in T11: | Up | Up | 0 | 0 | 0 | 0 | Up | Up |
| Lese T11 und T12: | Ur | Ur | 0 | 0 | 0 | Ur' | 0 | Ur' |

Darin bedeuten UP = Programmierspannung,
Ur = Lesespannung $\leqslant$ Up,
Ur' = effektive Lesespannung = Ur - $\triangle$ U und
$\triangle$ U = Spannungsabfall am Lastelement

Die Topographie einer in einer solchen Speichermatrix verwendbaren Halbleiter-Speicherzelle nach der Erfindung zeigt die Fig. 3. Die nicht von Elektrodenteilen bedeckten Teile der Zonenstreifen S1 und D1 einerseits und die nicht von den Leiterstreifen F1 und G1 bedeckten Teile von polykristallinen Siliciumschichten andererseits zeigen unterschiedliche Schraffuren. Die Programmier-Leiterstreifen F und die Lösch-Leiterstreifen G verlaufen quer zu den Source-Zonenstreifen S und den Drain-Zonenstreifen D. Auf der unmittelbar auf den Drain-Zonenstreifen D aufgebrachten Schreib-Elektrode 4 aus polykristallinem Silicium ist innerhalb der Schreib-Übergangsfläche W die erste Isolierschicht 7 durch thermische Oxidation erzeugt worden. Nach Herstellung des Gateoxids 12 wird anschliessend durch einen zweiten Aufbringungsprozess von polykristallinem Silicium die Gate-Elektrode 1 mit einem ersten Elektrodenteil 1' über der Schreib-Elektrode 4 und einem zweiten Elektrodenteil 1'' unterhalb der noch herzustellenden Lösch-Elektrode oberhalb der zweiten Isolierschicht 8 hergestellt. Unter Anwendung herkömmlicher Oxidations-, Aufbringungs- und photolithographischer Ätzprozesse werden die dritte Isolierschicht 10 und die zweite Isolierschicht 8 durch thermische Oxidation innerhalb von Öffnungen eines Dickoxids hergestellt. Durch Aufdampfen und einen photolithographischen Ätzprozess werden anschliessend quer zu den Source-Zonenstreifen S und den Drain-Zonenstreifen D unter Anwendung eines Aufdampfprozesses und eines photolithographischen Ätzprozesses die Programmier-Leiterstreifen F, welche die dritten Isolierschichten 10 bedecken, und die Lösch-Leiterstreifen G, welche über die Lösch-Übergangsflächen E verlaufen, erhalten.

Die Fig. 4 zeigt ein weiteres Ausführungsbeispiel der Halbleiter-Speicherzelle nach der Erfindung. Unterschiedlich zu der Halbleiter-Speicherzelle nach Fig. 3 sind nach der Fig. 4 sowohl die Lösch-Übergangsfläche E als auch die Schreib-Übergangsfläche W unter dem Lösch-Leiterstreifen G1 angeordnet. Die Herstellung der Source-Zonenstreifen S und der Drain-Zonenstreifen D erfolgt wie bei allen Ausführungsbeispielen in bekannter Weise durch einen Planar-Diffusionsprozess. Die weitere Herstellung macht von zwei Aufbringungsprozessen von polykristallinem Silicium Gebrauch. Beim ersten Aufbringungsprozess werden die Schreib-Elektrode unmittelbar auf freigelegte Teile des Drain-Zonenstreifens D und die Gate-Elektrode 1 mit Teilen erzeugt, die unterhalb des Programmier-Leiterstreifens F1 mit der dritten Isolierschicht 10 die Programmier-Elektrode und innerhalb der Lösch-Übergangsfläche E oberhalb der zweiten Isolierschicht 8 mit dem Lösch-Leiterstreifen G die Lösch-Elektrode bilden. Die Erzeugung der Isolierschichten und der Leiterstreifen erfolgt in bekannter Weise,wie bereits beschrieben. An den Leiterstreifen ist zum Zeichen, dass diese Leiterstreifen aus Metall hergestellt werden, das Symbol Al für Aluminium angebracht worden, da Aluminium das für Leiterstreifen in der Halbleitertechnik am häufigsten verwendete Material ist.

Wiederum sind die von Elektrodenteilen nicht bedeckten Zonenbereiche und Teile aus polykristallinem Silicium unterschiedlich schraffiert, was auch für die übrigen Figuren gilt.

Die Fig. 5 zeigt nun in Aufsicht die Topographie einer Speicherzelle der Erfindung entsprechend eines dritten Ausführungsbeispiels, bei dem lediglich ein Aufbringungsprozess von polykristallinem Silicium erforderlich ist. Dieses Ausführungsbeispiel der Fig. 5 bis 8 kann daher in einer Standard-n-Kanal-Silicon-Gate-Technologie mit nur einem einzigen zusätzlich eingeschobenen Photoprozess und darauffolgender Dünnschicht-Oxidation der ersten Isolierschicht 7, der zweiten Isolierschicht 8 und der dritten Isolierschicht 10 gefertigt werden. Die Herstellung der Halbleiter-Speicherzelle gemäss den Fig. 5 bis 8 erfolgt, wie im folgenden Absatz beschrieben.

Zunächst wird eine Oxidationsmaskierungsschicht aufgebracht, welche die Halbleiteroberfläche innerhalb der in der Fig. 5 angegebenen SDG-Linie gegen eine thermische Oxidation schützt. Nach der thermischen Oxidation, bei der das Dickoxid gebildet wird, wird das Gateoxid 12 im Gatebereich zwischen den als Ansätze der Source-Zonenstreifen S und Drain-Zonenstreifen D ausgebildeten Source-Zonen bzw. Drain-Zonen durch thermische Oxidation der dort freigelegten Halbleiteroberfläche erzeugt. Als Material der Oxidationsmaskierungsmaske kann Siliciumnitrid verwendet werden, welches durch heisse Phosphorsäure bei Verwendung einer Ätzmaskierung aus Siliciumoxid oder durch Plasmaätzung bei Verwendung einer Maskierung aus Photolack entfernt werden kann. Anschliessend wird der übrige Teil der Oxidationsmaskierungsmaske entfernt und über die oxidierte Hauptfläche der Anordnung eine polykristalline n-dotierte Siliciumschicht aufgebracht. Aus dieser werden die Gate-Elektrode 1 mit ihren Ansätzen und die Schreib-Elektrode 4 herausgeätzt. Es erfolgt nun ein n-dotierender Diffusionsprozess, vorzugsweise unter Verwendung von Phosphor als Dotierungsmittel, wodurch die Source-Zonenstreifen S und die Drain-Zonenstreifen D und unter der als Diffusionsquelle wirksamen Schreib-Elektrode 4 ein Zonenbereich 15 gebildet wird. Nach Freilegung der entsprechenden Bereiche des polykristallinen Siliciums durch einen photolithographischen Ätzprozess werden dann, wie bereits erwähnt, innerhalb der Lösch-Übergangsfläche E die zweite Isolierschicht 8, innerhalb der Schreib-Übergangsfläche W die erste Isolierschicht 7 und die dritte Isolierschicht 10 erzeugt. Es werden nun eine erste Fremdoxidschicht 13 aufgebracht und auf photolithographischem Weg Kontaktierungsöffnungen zu den Gate-Elektroden 1 einerseits und den Schreib-Elektroden 4 andererseits hergestellt. Anschliessend wird über die Hauptfläche der Anordnung eine Metallschicht, insbesondere aus Aluminium, aufgedampft und auf photolithographischem Weg ein Metallmuster erzeugt, welches die Lösch-Leiterstreifen G, die Programmier-Leiterstreifen F und die Verbindungsstreifen 16 zwischen den Gate-Elektroden 1 einerseits und den Schreib-Elektroden 4 andererseits enthält. Schliesslich wird über die Hauptfläche der gesamten Anordnung als Schutzschicht die zweite Fremdoxidschicht (Silox) aufgebracht.

Die Fig. 9 zeigt in Aufsicht in Weiterbildung der Speicherzelle nach der Erfindung die Topographie einer Speicherzelle, die auf der Source-Seite des Speichertransistors noch einen Enhancement-Lese-Feldeffekttransistor Tr aufweist, der mit dem Speichertransistor in Serie liegt und dessen Steuer-Elektrode mit dem Programmier-Leiterstreifen F bzw. mit der Programmier-Elektrode verbunden ist. Dieser Lese-Isolierschicht-Feldeffekttransistor Tr macht es möglich, beim Löschen den Speichertransistor bis in den Verarmungs-Betrieb zu fahren, ohne Fehler beim Auslesen der Speichermatrix befürchten zu müssen. Der zusätzliche Lese-Isolierschicht-Feldeffekttransistor Tr garantiert auch in diesem Fall die Unterbrechung der Strecke zwischen dem Source-Zonenstreifen S und dem Drain-Zonenstreifen D in allen nicht-adressierten Speicherzellen der adressierten Spalte, was für ein einwandfreies Lesen unabdingbar ist.

Die Herstellung der Speichermatrix mit Speicherzellen gemäss der Fig. 9 erfolgt in gleicher Weise, wie anhand der Fig. 6 bis 8 beschrieben. Die Steuer-Elektroden der Lese-Isolierschicht-Feldeffekttransistoren Tr werden gleichzeitig mit der Gate-Elektrode 1 und der Schreib-Elektrode 4 hergestellt. Die Fig. 10 zeigt das Ersatzschaltbild einer 2 × 2-Bit-Matrix mit vier Halbleiter-Speicherzellen nach der Fig. 9 auf und stellt im Hinblick auf den vorstehend erwähnten Vorteil eine bevorzugte Verwendungsform einer Speicherzelle nach der Erfindung dar.

Die Fig. 11 und 12 veranschaulichen in Querschnittsansicht platzsparende Weiterbildungen der Halbleiter-Speicherzelle nach Fig. 9. Die Platzersparnis kommt dadurch zustande, dass die zwischen der Steuer-Elektrode S des Lese-Isolierschicht-Feldeffekttransistors Tr und der Gate-Elektrode 1 im Halbleiterkörper liegende Zone nach Art eines Zweifach-Gate-Feldeffekttransistors entfällt und dieser Feldeffekttransistor Tr durch eine überlappende Gate-Elektrode mit dem Speichertransistor «verschmolzen» worden ist. Man kann diese Speicherzelle gemäss der Fig. 11 mit den schraffierten Elektrodenteilen aus polykristallinem Silicium zwar unter Anwendung von drei aufeinanderfolgenden Aufbringungsprozessen von polykristallinem Silicium realisieren; zur Wahrnehmung des eingangs erwähnten Effekts eines erleichterten Tunnelns von einem polykristallinen Silicium-Elektrodenteil durch eine darauf durch thermische Oxidation aufgebrachte erste Isolierschicht 7 bzw. zweite Isolierschicht 8 ist es jedoch nur erforderlich, die Schreib-Elektrode 4 und den unter der Lösch-Elektrode 3 liegenden Elektrodenteil der Gate-Elektrode 1 aus polykristallinem Silicium herzustellen, so dass auch bei der Speicherzelle gemäss der Fig. 11 zur Herstellung ein Aufbringprozess von n-dotiertem polykristallinem Silicium erforderlich ist.

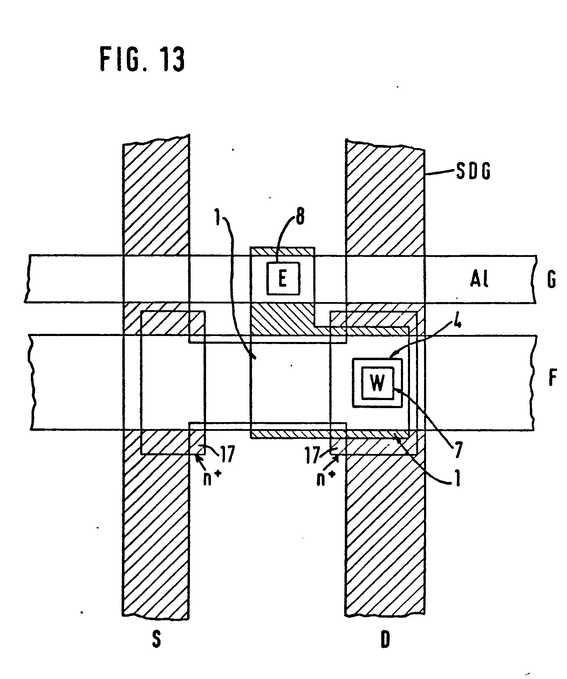

Bei einer weiteren Verkleinerung der Halbleiter-Speicherzelle nach der Erfindung muss jedoch auf die Verbindungsstreifen 16 zwischen der Schreib-Elektrode 4 und der Gate-Elektrode 1 verzichtet werden, weil die dazu erforderlichen Kontaktierungsöffnungen einen Mindestplatz beanspruchen. Die Topographie gemäss der Fig. 13 einer Speicherzelle gemäss der Fig. 11 für besonders geringen Platzbedarf ohne solche Verbindungsstreifen macht daher ein mehrmaliges Aufbringen von polykristallinem Silicium erforderlich. Zur Einstellung der Kanallänge werden vor dem Aufbringen der Nitridmaskierungsschicht innerhalb der SDG-Linie in die Oberfläche des Substrats $n^+$-dotierte Zonen 17 unter Anwendung eines Planardiffusionsprozesses eindiffundiert. Zur Herstellung der Schreib-Elektrode 4 erfolgt ein erster Prozess zum Aufbringen von polykristallinem Silicium und zur Herstellung der Gate-Elektrode 1 ein zweiter Aufbringungsprozess von polykristallinem Silicium. Der Programmier-Leiterstreifen kann entweder aus einem Metall oder aus polykristallinem Silicium hergestellt werden.

Die Ausführungsform gemäss der Fig. 12 in gleicher Querschnittsansicht wie die Fig. 11 veranschaulicht, wie bei geringstem Flächenbedarf die für das Programmieren und Löschen wichtigen Flächenverhältnisse zwischen der durch die dritte Isolierschicht 10 gegebenen Kapazität der Programmier-Elektrode, der Schreib-Übergangsfläche W und der Lösch-Übergangsfläche E eingehalten werden können.

Bei dieser Ausführungsform ist über Elektrodenteile der Gate-Elektrode 1 auf Teilen der Programmier-Elektrode 2 eine Isolierschicht 10' und darauf eine Leitschicht 2' angeordnet, welche mit der Gate-Elektrode 1 kontaktiert ist.

Die Ausführungsform gemäss der Fig. 12 macht es daher bei geringstem Flächenbedarf möglich, die Kapazität zwischen der Programmier-Elektrode 2 und der Gate-Elektrode 1 genügend gross zu machen, sowohl gegenüber der Kapazität zwischen der Lösch-Elektrode 3 und der Gate-Elektrode 1 als auch gegenüber der Kapazität zwischen der Schreib-Elektrode 4 und der Gate-Elektrode 1. Die Koppelkapazität der Programmier-Elektrode 2 mit der Gate-Elektrode 1 sollte nämlich grundsätzlich bei der Speicherzelle nach der Erfindung mindestens viermal grösser sein als die der Schreib-Elektrode 4 mit der Gate-Elektrode oder auch als die der Lösch-Elektrode 3 mit der Gate-Elektrode. Diese Bedingung ist bei einer Speicherzelle nach der Fig. 12 auch bei wesentlich grösseren Kapazitätsverhältnissen bei geringem Flächenbedarf realisierbar.

Beim Programmieren dient die Programmier-Elektrode als eine Art von Bootstrap-Kapazität zur Gate-Elektrode 1 und bestimmt jeweils das Potential derselben. Die dritte Isolierschicht 10 als Dielektrikum dieser Kapazität kann aufgrund der die Kapazitätsverhältnisse bestimmenden Flächenverhältnisse aus dem gleichen Material in der gleichen Dicke wie die der ersten Isolierschicht 7 und die der zweiten Isolierschicht 8 bestehen, da entsprechend den Flächenverhältnissen an der dritten Isolierschicht eine wesentlich geringere Spannung abfällt, so dass ein Tunneln von Ladungsträger durch die dritte Isolierschicht 10 ausgeschlossen wird. Ein Vorteil der Halbleiter-Speicherzelle nach der Erfindung liegt darin, dass die Programmier- und Lesespannung gleich gross und relativ niedrig, beispielsweise 12 Volt, sein können.

Eine günstige Wirkung auf die Degradation der Speicherzelle wird dadurch erreicht, dass die Tunnel-Injektionen ausserhalb der Kanalzone stattfinden.

## Patentansprüche

1. Floating-Gate-Speicherzelle, bestehend aus einem n-Kanal-Feldeffekttransistor, dessen potentialmässig schwebende Gate-Elektrode einen ersten Elektrodenteil, welcher für die Tunnel-Injektionen von Elektronen in die Gate-Elektrode (1) kapazitiv an eine Schreib-Elektrode (4) angekoppelt ist, und einen zweiten Elektrodenteil aus polykristallinem Silicium aufweist, der für die Tunnel-Emissionen von Elektronen aus der Gate-Elektrode (1) beim Löschen kapazitiv an eine Lösch-Elektrode (3) gekoppelt ist, dadurch gekennzeichnet, dass die Gate-Elektrode (1) ausserdem kapazitiv an eine Programmier-Elektrode (2) gekoppelt ist, dass die Schreib-Elektrode (4) im sperrfreien Kontakt unmittelbar auf der Drain-Zone (5) des Feldeffekttransistors aufgebracht ist und dass die Koppelkapazität der Programmier-Elektrode (2) zur Gate-Elektrode (1) grösser ist als die der Schreib-Elektrode (4) zur Gate-Elektrode (1) und die der Lösch-Elektrode (3) zur Gate-Elektrode (1).

2. Speicherzelle nach Anspruch 1, dadurch gekennzeichnet, dass die Schreib-Elektrode (4) über eine erste Isolierschicht (7) aus einem durch Oxidation auf der Schreib-Elektrode (4) gewachsenen Siliciumoxid kapazitiv mit der Gate-Elektrode (1) und die Lösch-Elektrode (3) über eine zweite Isolierschicht (8) aus einem durch Oxidation auf der Gate-Elektrode (1) gewachsenen Siliciumoxid kapazitiv mit der Gate-Elektrode (1) gekoppelt sind.

3. Speicherzelle nach Anspruch 2, dadurch gekennzeichnet, dass die Dicke der ersten Isolierschicht (7) und die der zweiten Isolierschicht (8) zwischen 10 nm (100ÅE) und 80 nm (800 ÅE) liegt.

4. Speicherzelle nach einem der Ansprüche 1 bis 3, gekennzeichnet durch eine Drain-Zone (5) und eine Source-Zone (9), welche mit weiteren Drain-Zonen bzw. weiteren Source-Zonen weiterer Speicherzellen einer Speichermatrix in Form von zusammenhängenden und parallel zueinander verlaufenden Zonenstreifen (S, D) für jede der Drain-Zonen bzw. jede der Source-Zonen ausgebildet sind.

5. Speicherzelle nach Anspruch 4, dadurch gekennzeichnet, dass zwischen der Source-Zone und dem Source-Zonenstreifen (S) je ein Lese-Isolierschicht-Feldeffekttransistor (Tr) in Serie angeordnet ist, dessen Steuer-Elektrode mit der Programmier-Elektrode (2) kontaktiert ist.

6. Speicherzelle nach Anspruch 5, dadurch gekennzeichnet, dass zwischen den Source-Zonenstreifen (S) und der Gate-Elektrode (1) auf einem Teil des Gate-Oxids ein Programmier-Elektrodenteil (2') verläuft, der die Steuer-Elektrode des Lese-Isolierschicht-Feldeffekttransistors bildet.

7. Speicherzelle nach einem der Ansprüche 4 bis 6, dadurch gekennzeichnet, dass die Lösch-Elektrode (3) und die Programmier-Elektrode (2) von zwei parallel zueinander und rechtwinklig zu den Drain-Zonen (D) sowie zu den Source-Zonen (S) verlaufenden Leiterstreifen (F, G) über der zweiten Isolierschicht (8) bzw. einer dritten Isolierschicht (10) gebildet sind.

8. Speicherzelle nach einem der Ansprüche 1 bis 7, dadurch gekennzeichnet, dass die Lösch-Elektrode (3) und die Programmier-Elektrode (2) aus Metall bestehen.

9. Speicherzelle nach Anspruch 8, dadurch gekennzeichnet, dass die Lösch-Übergangsfläche (E) der Lösch-Elektrode (G) unter der Lösch-Elektrode (G) und die Schreib-Übergangsfläche (W) der Schreib-Elektrode (4) in dem nicht von der Schreib-Elektrode (4) und der Lösch-Elektrode (G) bedeckten Bereich zwischen diesen Elektroden angeordnet sind.

10. Speicherzelle nach einem der Ansprüche 1 bis 9, dadurch gekennzeichnet, dass sowohl die Gate-Elektrode (1) als auch die Schreib-Elektrode (4) sowie die unmittelbar unter der Schreib-Elektrode (4) liegende Drain-Zone (5) an der Oberfläche des einkristallinen Substrats (6) n-dotiert sind.

11. Speicherzelle nach einem der Ansprüche 1 bis 10, dadurch gekennzeichnet, dass über Elektrodenteilen der Gate-Elektrode (1) auf Teilen der Programmier-Elektrode (2) eine Isolierschicht (10') und darauf eine Leitschicht (2') angeordnet sind, welche mit der Gate-Elektrode (1) kontaktiert ist.

12. Speicherzelle nach einem der Ansprüche 1 bis 11, dadurch gekennzeichnet, dass sowohl die Koppelkapazität der Programmier-Elektrode (2) zur Gate-Elektrode (1) mindestens viermal grösser ist als die der Schreib-Elektrode (4) zur Gate-Elektrode (1) als auch als die der Lösch-Elektrode (3) zur Gate-Elektrode (1).

## Claims

1. Floating-gate storage cell consisting of an n-channel field-effect transistor whose potentially floating gate electrode comprises a first electrode part which, for effecting the tunnel injections of electrons into the gate electrode (1), is coupled capacitively to a writing electrode (4), as well as a second electrode part of polycrystalline silicon which, for effecting the tunnel emissions of electrons from said gate electrode (1) during the erasing operation, is coupled capacitively to an erasing electrode (3), characterized in that moreover said gate electrode (1) is coupled capacitively to a programming electrode (2), that said writing electrode (4) is connected directly in a barrier-free contact to the drain zone (5) of the field-effect transistor, and that the coupling capacitance of said programming electrode (2) towards said gate electrode (1) is greater than that of said writing electrode (4) towards said gate electrode (1) and greater than that of said erasing electrode (3) towards said gate electrode (1).

2. A storage cell as claimed in claim 1, characterized in that said writing electrode (4), via a first insulating layer (7) of a silicon oxide grown by way of oxidation on said writing electrode (4), is coupled capacitively to said gate electrode (1) and that said erasing electrode (3), via a second insulating layer (8) of a silicon oxide grown by way of oxidation on said gate electrode (1) is coupled capacitively to said gate electrode (1).

3. A storage cell as claimed in claim 2, characterized in that the thickness of both said first insulating layer (7) and of said second insulating layer (8) ranges between 10 nm (100 Å.U.) and 80 nm (800 Å.U.) respectively.

4. A storage cell as claimed in any one of claims 1 to 3, characterized by a drain zone (5) and a source zone (9) which, together with further drain zones or further source zones of further storage cells of a storage matrix, are designed to have the shape of continuous zone strips (S, D) extending parallel in relation to one another, for each of said drain zones or each of said source zones.

5. A storage cell as claimed in claim 4, characterized in that one reading insulated-gate field-effect transistor (Tr) each is arranged in series between said source zone and said source zone strip (S), whose gate electrode is in contact with said programming electrode (2).

6. A storage cell as claimed in claim 5, characterized in that one programming electrode part (2') extends between said source zone strips (S) and said gate electrode (1) on a portion of the gate oxide, with said part forming the gate electrode of said reading insulated-gate field-effect transistor.

7. A storage cell as claimed in any one of claims 4 to 6, characterized in that both said erasing electrode (3) and said programming electrode (2) are formed by two conductor strips (F, G) extending parallel in relation to one another and rectangularly in relation to said drain zones (D) as well as to said source zones (S), i.e. over the second insulating layer (8) or a third insulating layer (10).

8. A storage cell as claimed in any one of claims 1 to 7, characterized in that both said erasing electrode (3) and said programming electrode (2) consist of metal.

9. A storage cell as claimed in claim 8, characterized in that the erasing transition surface (E) of said erasing electrode (G) is arranged below said erasing electrode (G), and that the writing transition surface (W) of said writing electrode (4) is arranged in the area between these electrodes not covered by either said writing electrode (4) or said erasing electrode (G).

10. A storage cell as claimed in any one of claims 1 to 9, characterized in that said gate electrode (1) as well as said writing electrode (4) and the drain zone (5) as disposed directly below said writing electrode (4), are n-doped at the surface of said monocrystalline substrate (6).

11. A storage cell as claimed in any one of claims 1 to 10, characterized in that over electrode parts of said gate electrode (1) on parts of said programming electrode (2) there is arranged an insulating layer (10') and thereupon a conducting layer (2') which is in contact with said gate electrode (1).

12. A storage cell as claimed in any one of claims 1 to 11, characterized in that the coupling capacitance of said programming electrode (2) towards said gate electrode (1) is at least four times greater than the coupling capacitance of said erasing electrode (3) towards said gate electrode (1) as well as than said writing electrode (4) towards said gate electrode (1).

**Revendications**

1. Cellule de mémoire à grille flottante consistant en un transistor à effet de champ à canal N dont l'électrode de grille à potentiel flottant comprend une première partie d'électrode, laquelle, en vue de l'injection par effet tunnel d'électrons dans l'électrode de grille (1), est couplée capacitivement à une électrode d'écriture (4), ainsi qu'une seconde partie d'électrode, en silicium polycrystallin, laquelle, pour l'émission par effet tunnel d'électrons à partir de ladite électrode de grille (1) durant dans l'opération d'effacement, est couplée capacitivement à une électrode d'effacement (3), caractérisé en ce que, en outre ladite électrode de grille (1) est couplée capacitivement à une électrode de programmation (2), ladite électrode d'écriture (4) est connecté directement, sans barrière de contact, à la zone de drain (5) de transistor à effet de champ, la capacité de couplage de ladite électrode de programmation (2) à l'égard de ladite électrode de grille (1) étant plus grande que celle de ladite électrode d'écriture (4) par rapport à ladite électrode de grille (1) et plus grande que celle de ladite électrode d'effacement (3) par rapport à ladite électrode de grille (1).

2. Cellule de mémoire telle que définie en 1, caractérisée en ce que ladite électrode d'écriture (4), via une première couche isolante (7) en silice obtenue par oxydation sur ladite électrode d'écriture (4), est couplée capacitivement à ladite électrode de grille (1) et en ce que ladite électrode d'effacement (3), via une seconde couche isolante (8) en silice obtenue par oxydation sur ladite électrode de grille (1), est couplée capacitivement à ladite électrode de grille (1).

3. Cellule de mémoire telle que définie en 2, caractérisée par le fait que l'épaisseur de ladite première couche isolante (7) et celle de la seconde couche isolante (8) sont comprises dans la gamme de 10 à 80 nm respectivement.

4. Cellule de mémoire telle que définie dans l'une des revendications 1 à 3, caractérisée par le fait qu'elle comprend aussi une zone de drain (5) et une zone de source (9) lesquelles, avec les autres zones de drain et autres zones de source d'autres cellules d'enregistrement d'une matrice de mémoire, sont conçues pour avoir la forme de bandes de zones continues (S, D) s'étendant parallèlement les unes aux autres, pour ce qui concerne lesdites zones de drain ou lesdites zones de source.

5. Cellule de mémoire telle que définie en 4, caractérisée en ce qu'un transistor de lecture à effet de champ et grille isolée (Tr) est disposé en série avec chacune desdites bandes de zones de source et de zones de drain (S), son électrode de grille étant en contact avec ladite électrode de programmation (2).

6. Cellule de mémoire telle que définie en 5, caractérisée en ce qu'une partie (2') de l'électrode de programmation s'étend entre lesdites bandes de zones de source (S) et ladite électrode de grille (1) sur une portion de l'oxyde de grille formant l'électrode de grille dudit transistor de lecture à effet de champ et grille isolée.

7. Cellule de mémoire telle que définie dans l'une quelconque des revendications 4 à 6, caractérisée par le fait que ladite électrode d'effacement (3) et ladite électrode de programmation (2) sont formées par deux bandes conductrices (F, G) s'étendant parallèlement l'une à l'autre et perpendiculairement par rapport auxdites zones de drain (D) et auxdites zones de source (S), c'est-à-dire par-dessus la seconde couche isolante (8) ou une troisième couche isolante (10).

8. Cellule de mémoire telle que définie dans l'une quelconque des revendications 1 à 7, caractérisée par le fait que ladite électrode d'effacement (3) et ladite électrode de programmation (2) sont en métal.

9. Cellule de mémoire telle que définie en 8, caractérisée par le fait que la surface de transition d'effacement (E) de ladite électrode d'effacement (G) est disposée en-dessous de ladite électrode d'effacement (G) et en que la surface de transition d'écriture (W) de ladite électrode d'écriture (4) est disposée dans un emplacement entre ces électrodes non couvert par ladite électrode d'écriture ou ladite électrode d'effacement.

10. Cellule de mémoire telle que définie dans l'une quelconque des revendications 1 à 9, caractérisée par le fait que ladite électrode de grille (1), de même que ladite électrode d'écriture (4) et la zone de drain (5), disposée directement en-dessous de ladite électrode d'écriture, sont des domaines ayant reçu un dopage de type N à la surface dudit substrat monocristallin (6).

11. Cellule de mémoire telle que définie dans l'une quelconque des revendications 1 à 10, caractérisée en ce que, au-dessus des parties d'électrode de ladite électrode de grille (1) et sur des parties de ladite électrode de programmation (2), est disposée sur une couche isolante (10'), surmontée d'une couche conductrice (2'), laquelle est en contact avec ladite électrode de grille (1).

12. Cellule de mémoire telle que définie dans l'une quelconque des revendications 1 à 11, caractérisée par le fait que la capacité de couplage de ladite électrode de programmation (2) par rapport à ladite électrode de grille (1) est au moins quatre fois plus grande que la capacité de couplage de ladite électrode d'effacement (3) par rapport à ladite électrode de grille (1) également à celle de ladite électrode d'écriture (4) par rapport à ladite électrode de grille (1).

FIG. 1

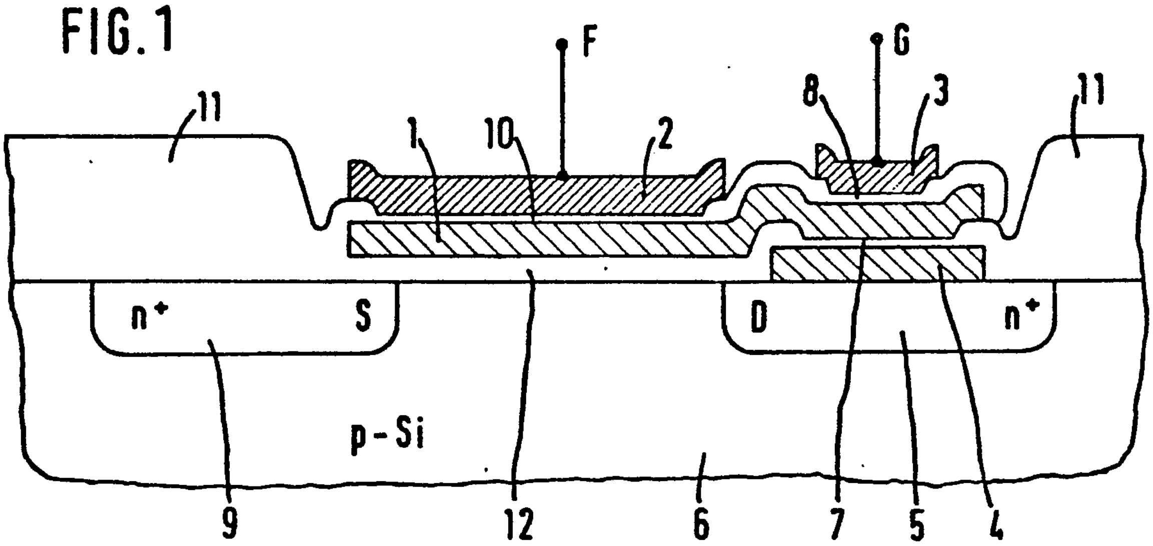
F
G
8
3
11
1
10
2
11
n+
S
D
n+
p-Si
9
12
6
7
5
4

FIG. 2

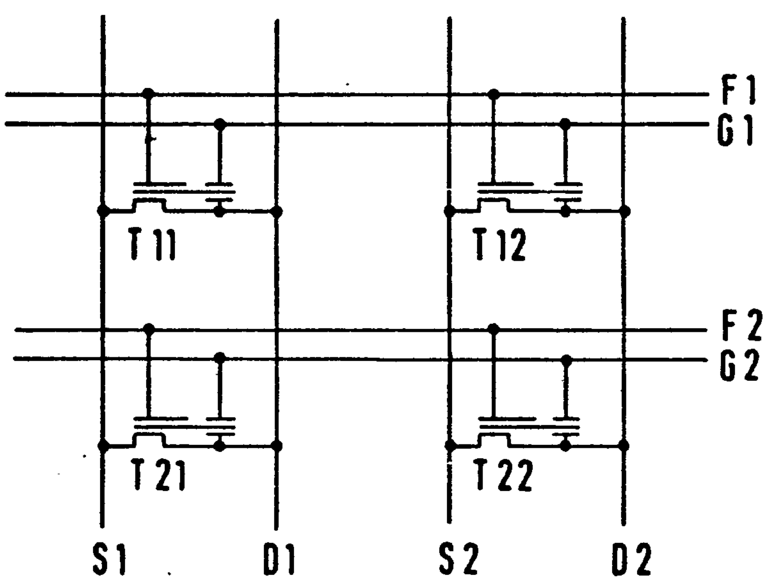
F1
G1
T11
T12
F2
G2
T21
T22
S1
D1
S2
D2

FIG. 3

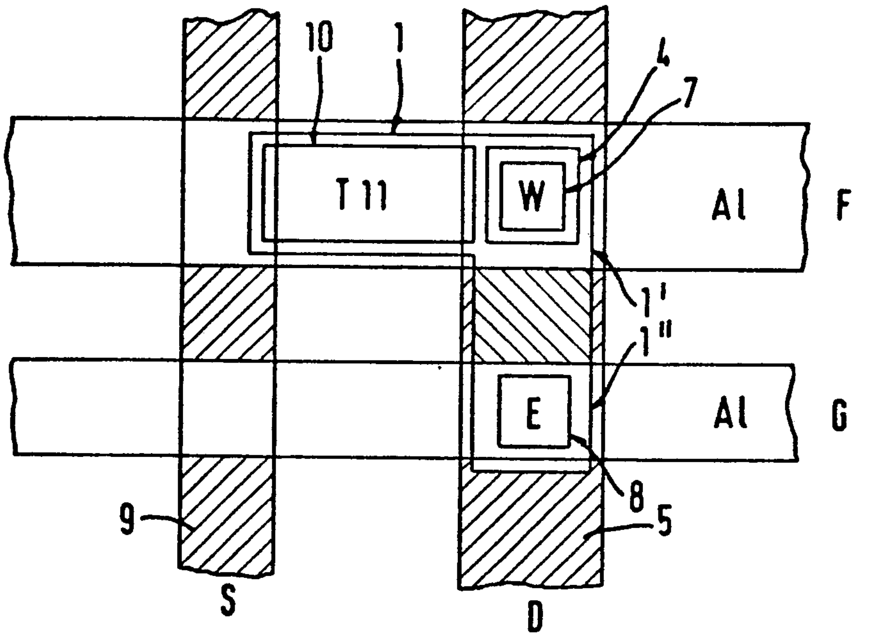


FIG. 4

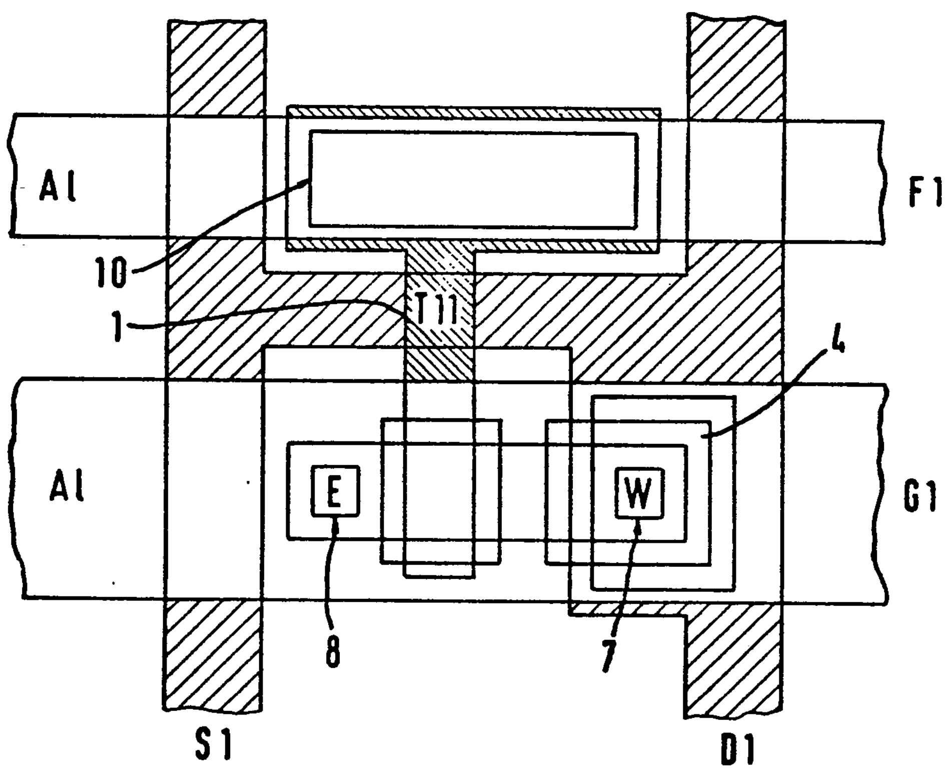

FIG. 5

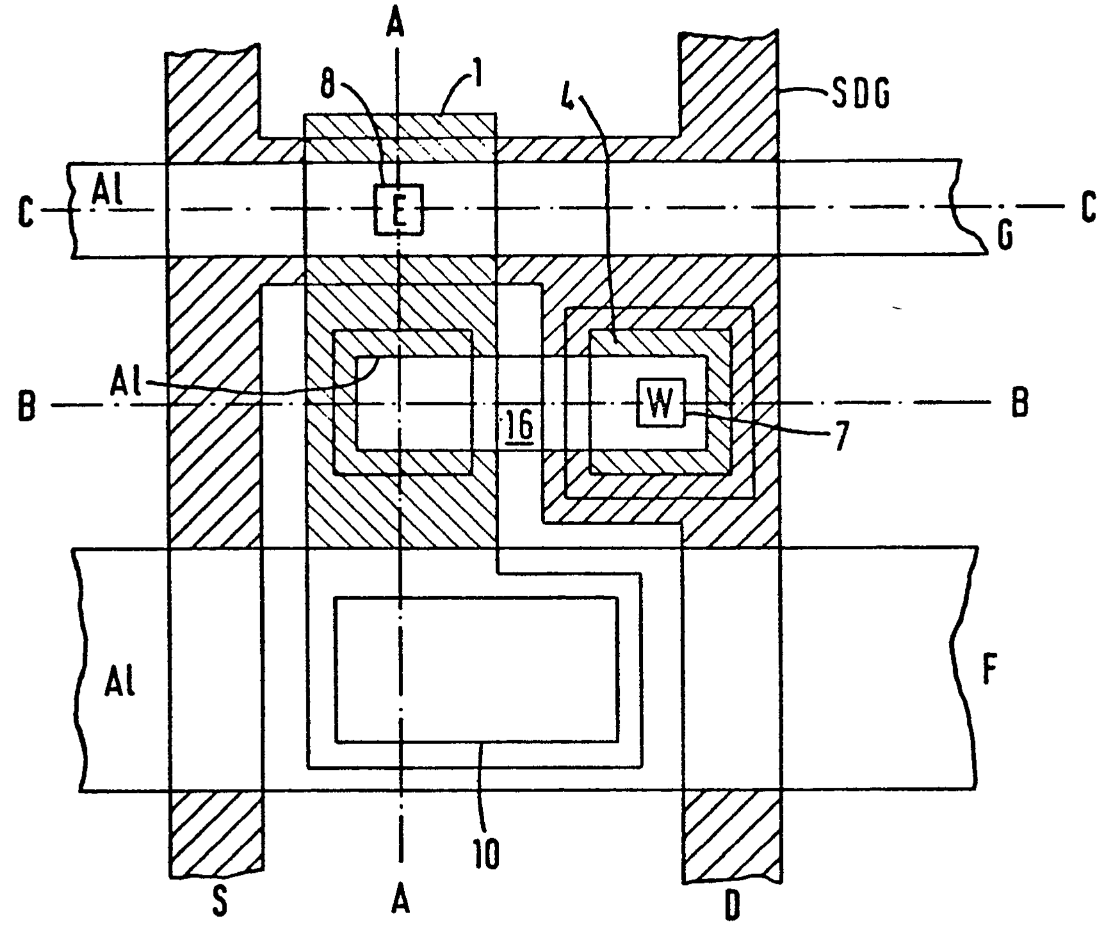
A
8
1
4
SDG
Al
C
E
C
G
B
Al
16
W
7
B
Al
F
10
S
A
D

FIG. 6

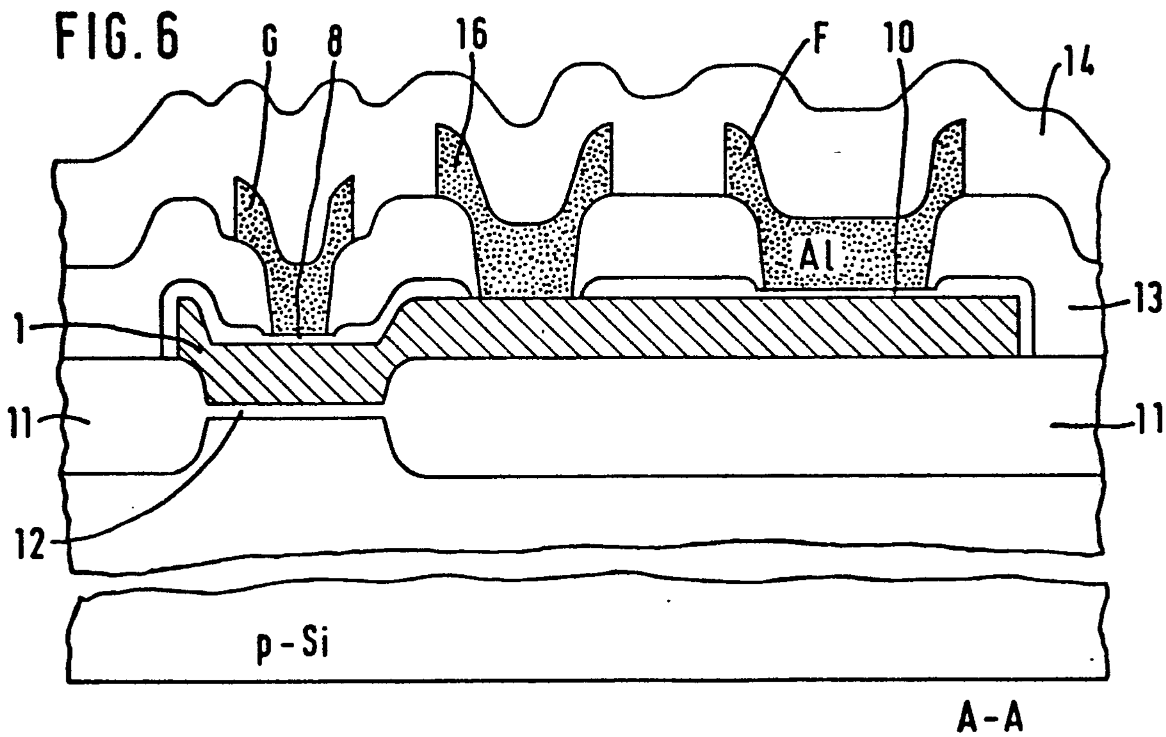
G
8
16
F
10
14
Al
13
1
11
11
12
p-Si
A-A

FIG. 7

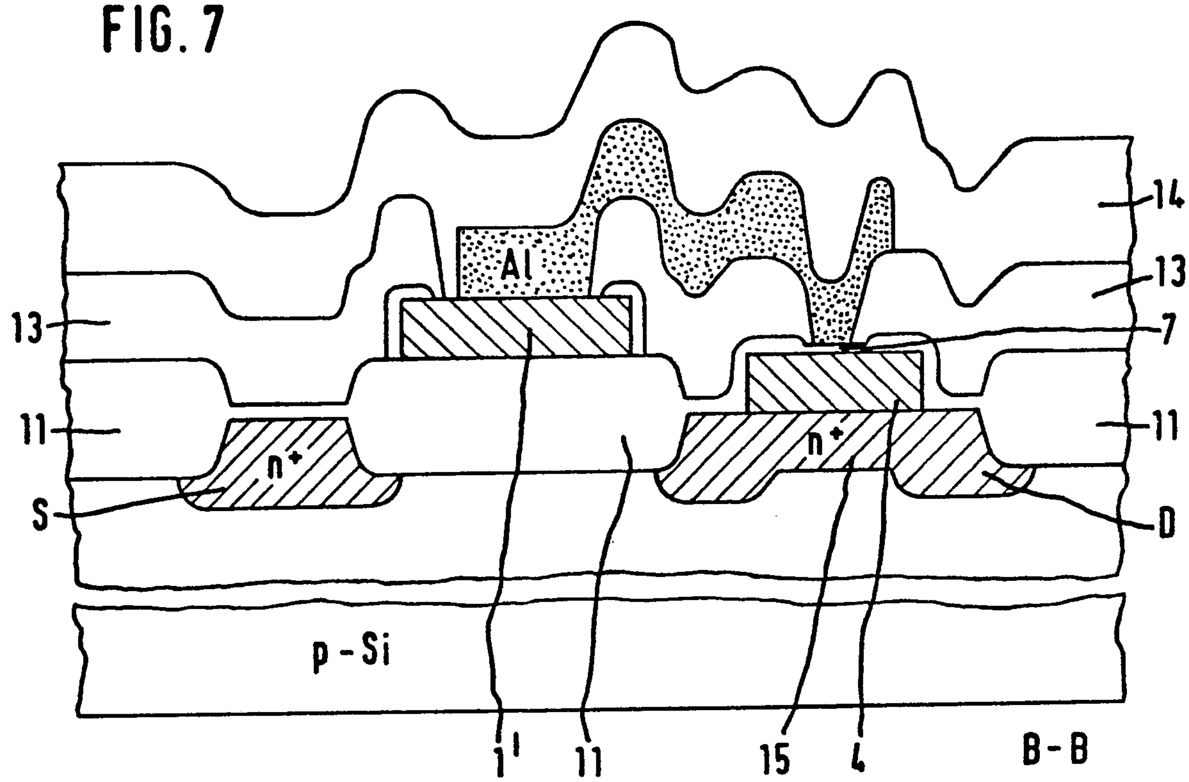
Al
14
13
13
7
11
11
n+
n+
S
D
p - Si
1'
11
15
4
B - B

FIG. 8

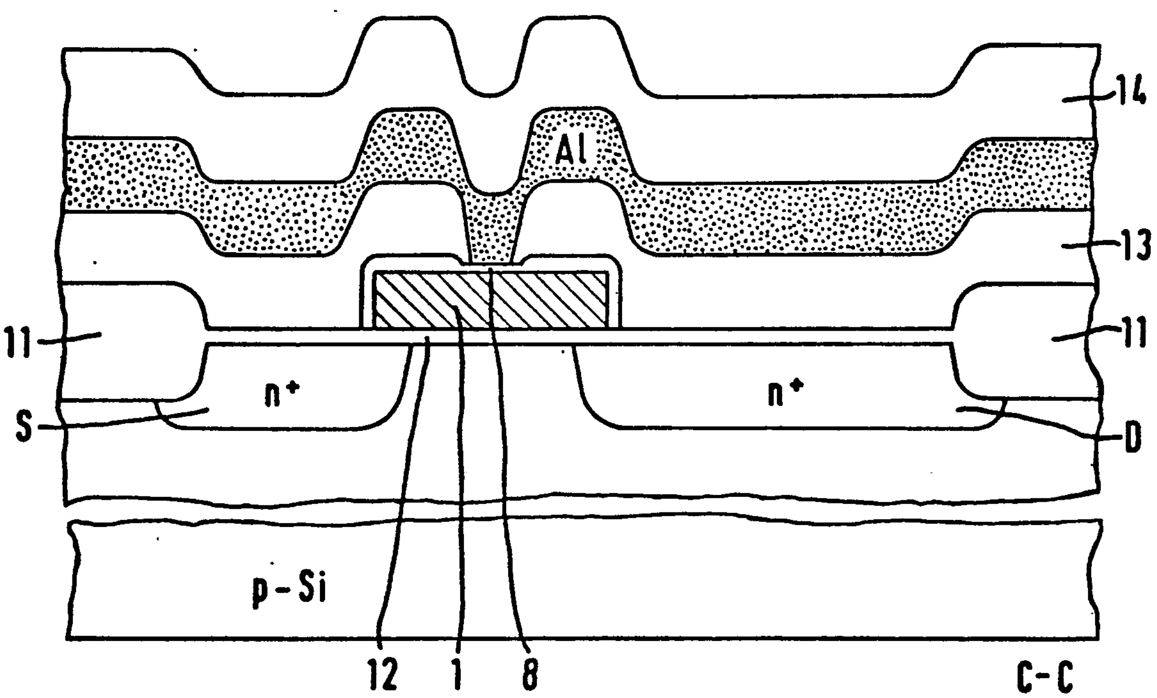
14
Al
13
11
11
n+
n+
S
D
p - Si
12
1
8
C - C

FIG. 9

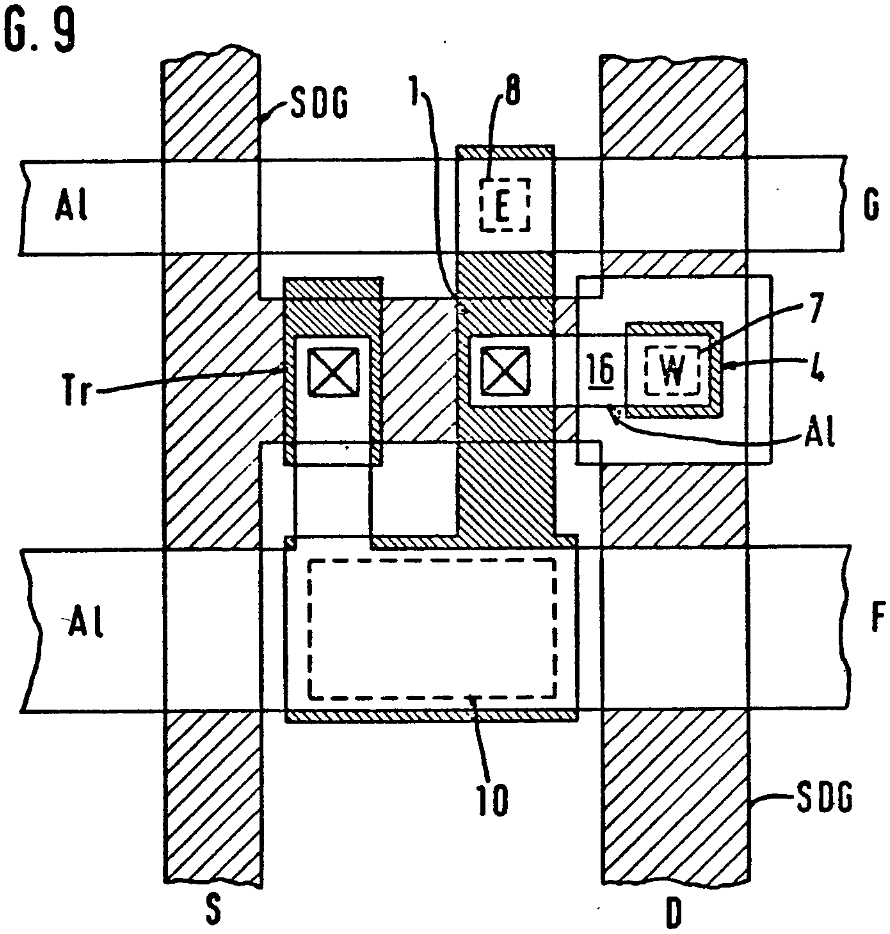
SDG
1
8
Al
E
G
Tr
7
16
W
4
Al
Al
F
10
SDG
S
D

FIG. 10

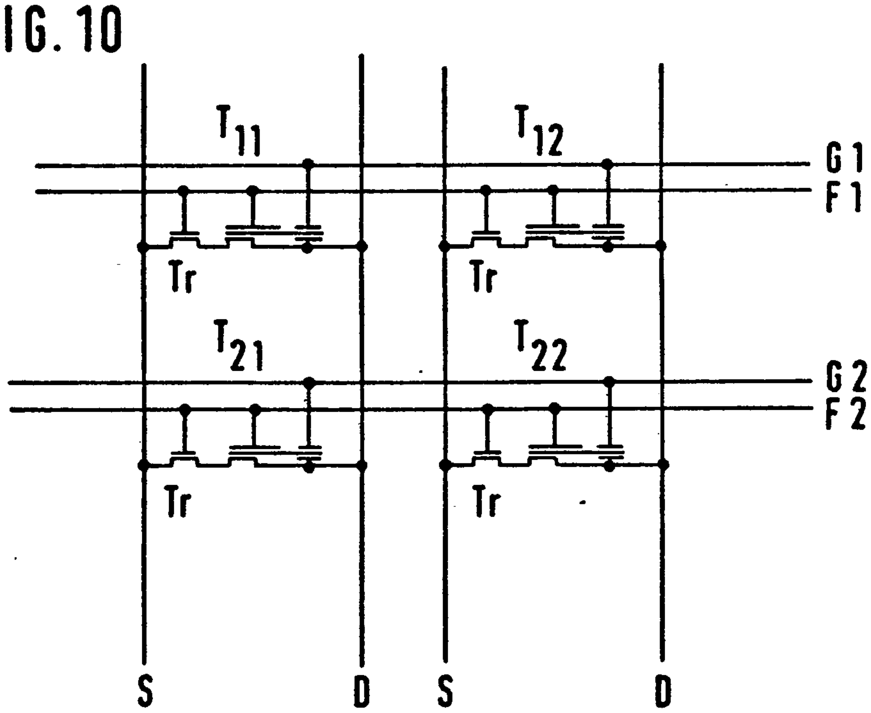
T11
T12
G1
F1
Tr
Tr
T21
T22
G2
F2
Tr
Tr
S
D
S
D

FIG. 11

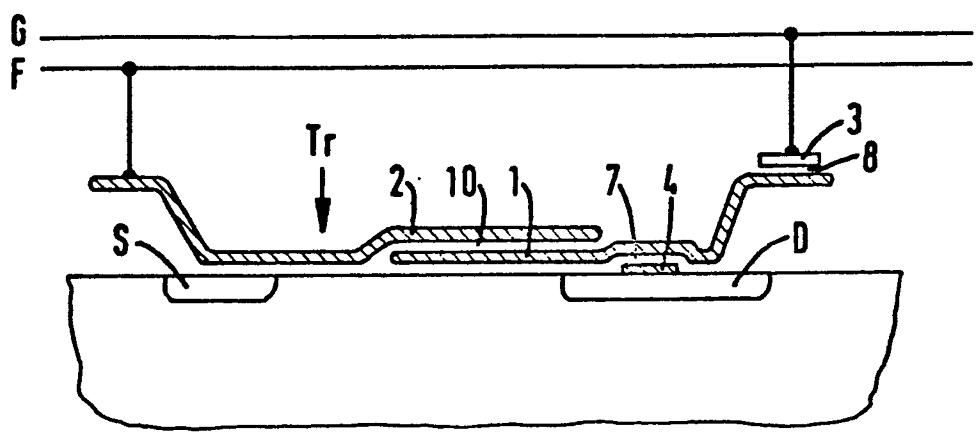


FIG. 12

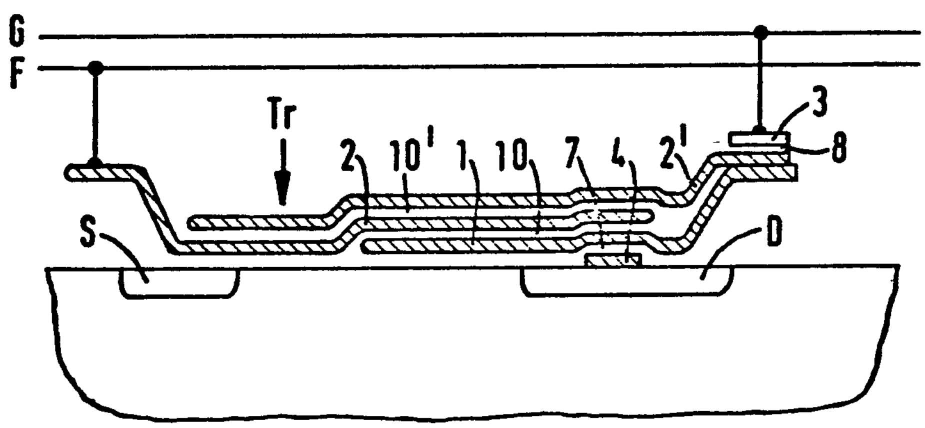

FIG. 13